# EUROPEAN PATENT APPLICATION

(11) **EP 4 645 684 A1**
(43) Date of publication of application: **05.11.2025**
(21) Application number: 24919172.7
(22) Date of filing: 22.08.2024
(51) Int. Cl.: H02S 40/32, H02M 7/00, H05K 7/14

(54) **MICROINVERTER**

(30) Priority: 06.03.2024 KR 20240031768
(71) Applicant: Hanwha Solutions Corporation, Jung-gu Seoul 04541 (KR)
(72) Inventor: KIM, Joongtae, Seoul 04541 (KR); KIM, Jungguen, Seoul 04541 (KR); PARK, Taesung, Seoul 04541 (KR)
(74) Representative: Mooser, Sebastian Thomas
(86) International application number: PCT/KR2024/012509
(87) International publication number: WO 2025/187881

(57) **Abstract**

The present disclosure relates to a microinverter including a case in which a circuit board is disposed therein, a first connector disposed at one side of the case and connected to the circuit board, a second connector disposed at another side of the case and connected to the circuit board, and a support bracket configured to support the case, wherein one of the case and the support bracket includes a first locker disposed at an edge thereof, and the other one of the case and the support bracket includes a second locker assembled with the first locker.

## Description

### Technical Field

The present disclosure relates to a microinverter.

### Background Art

Inverters are devices that convert a DC current into an AC current and are used in various industrial application fields that use electronic devices such as electric motor drives, uninterruptible power supplies (UPSs), and active power filters as well as fields of renewable energy conversion systems including solar power generators, hybrid vehicles, and the like.

Recently, microinverters are being applied in the solar power generation inverter market, mainly in the US market. Microinverters are distributed systems that convert a DC current into an AC current in a module unit by installing a small inverter on each individual solar cell module.

In a microinverter, a printed circuit board array (PCBA) which converts a current is seated in a case forming an exterior and is equipped with a DC connector connected to a solar cell module and an AC connector connected to an AC cable for distributing generated power. However, due to a miniaturized device size, a microinverter had a limitation in assembly stability of each component.

### Disclosure

### Technical Problem

The present disclosure is directed to providing a microinverter with improved structural stability and usability by more firmly assembling a case and components.

### Technical Solution

According to an aspect of the present disclosure, there is provided a microinverter including a case in which a circuit board is disposed therein, a first connector disposed at one side of the case and connected to the circuit board, a second connector disposed at another side of the case and connected to the circuit board, and a support bracket configured to support the case, wherein one of the case and the support bracket includes a first locker disposed at an edge thereof, and the other one of the case and the support bracket includes a second locker assembled with the first locker.

### Advantageous Effects

A microinverter according to an embodiment of the present disclosure, a first locker and a second locker connecting a case and a support bracket may form a firm assembly structure to improve resistance to external impact applied to an inverter, thereby preventing the case and the support bracket from being disassembled or damaged during transportation.

### Description of Drawings

FIG. 1 is a view illustrating a microinverter according to an embodiment of the present disclosure.
FIG. 2 is an exploded perspective view of the microinverter of FIG. 1.
FIG. 3 is an exploded perspective view of a first locker and a second locker of FIG. 1.
FIG. 4 is a partial cross-sectional view taken along line IV-IV' of FIG. 1.
FIG. 5 is an enlarged view of part B of FIG. 4.
FIG. 6 is a front view of part A of FIG. 1.

### Best Mode

An aspect of the present disclosure provides a microinverter including a case in which a circuit board is disposed therein, a first connector disposed at one side of the case and connected to the circuit board, a second connector disposed at another side of the case and connected to the circuit board, and a support bracket configured to support the case, wherein one of the case and the support bracket includes a first locker disposed at an edge thereof, and the other one of the case and the support bracket includes a second locker assembled with the first locker.

In addition, the first locker may include a buckle extending from the edge and having an insertion opening, a support bar extending across the insertion opening, and a mount protrusion extending downward from the buckle.

In addition, the mount protrusion may protrude in a thickness direction of the buckle and may protrude further outward of the buckle than toward the insertion opening.

In addition, a cross-sectional area of the mount protrusion may decrease in a direction in which the mount protrusion extends from the buckle.

In addition, the support bar may be spaced apart from one side of the insertion opening by a first interval and may be spaced apart from another side of the insertion opening by a second interval different from the first interval.

In addition, an upper surface of the support bar in contact with the second locker may have a first inclination, and a side surface of the support bar facing the second locker may have a second inclination.

In addition, the second locker may include a hook supported by the buckle of the first locker, and a mount groove into which mount protrusions of the first locker are inserted.

In addition, the hook may have an inclination in a height direction.

In addition, the pair of mount protrusions may support an inner surface of the mount groove.

In addition, the hook may include a locking protrusion supported by a support bar of the first locker.

### Mode for Invention

Since the present disclosure can apply various transformations and have various embodiments, specific embodiments will be illustrated in the drawings and described in detail in the detailed description. Effects and features of the present disclosure, and methods for achieving them will become clear with reference to the embodiments described below in detail together with the drawings. However, the present disclosure is not limited to the embodiments disclosed below and may be implemented in various forms.

Hereinafter, embodiments of the present disclosure will be described in detail with reference to the attached drawings. When describing with reference to the drawings, identical or corresponding components are given the same drawing reference numerals and redundant descriptions thereof are omitted.

In the following embodiments, the terms first, second, and the like do not have limited meaning but are used for the purpose of distinguishing one component from another component.

In the following embodiments, the expressions used in the singular such as "a," "an," and "the" are intended to include the plural forms as well, unless the context clearly indicates otherwise.

In the following embodiments, it will be understood that the terms such as "including," "comprising," and "having" specify the presence of stated features or components, but do not preclude the presence or addition of one or more other features or components.

In the following embodiments, when an area, a component, or the like is positioned on or above another part, the present disclosure includes not only a case in which the area, the component, or the like is positioned directly above the other part, but also a case in which other areas, other components, or the like may be positioned therebetween.

In the drawings, components may be exaggerated or reduced in size for convenience of description. For example, the size and thickness of each component shown in the drawing are arbitrarily shown for convenience of explanation, and thus the present disclosure is not necessarily limited to what is shown.

In the following embodiments, it will be understood that when an area, a component, or the like is referred to as being connected to another component, it may be directly connected to the other component or intervening components may also be present.

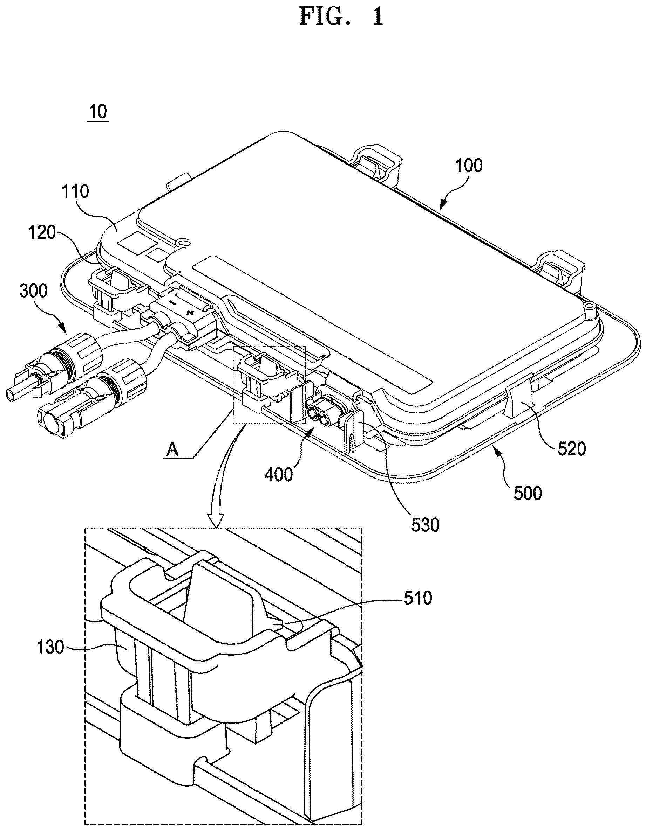

FIG. 1 is a view illustrating a microinverter according to an embodiment of the present disclosure.

Referring to FIG. 1, a microinverter 10 may include a first connector 300 and a second connector 400 which are connected to a case 100 storing a circuit board therein, and a support bracket 500 which supports the case 100.

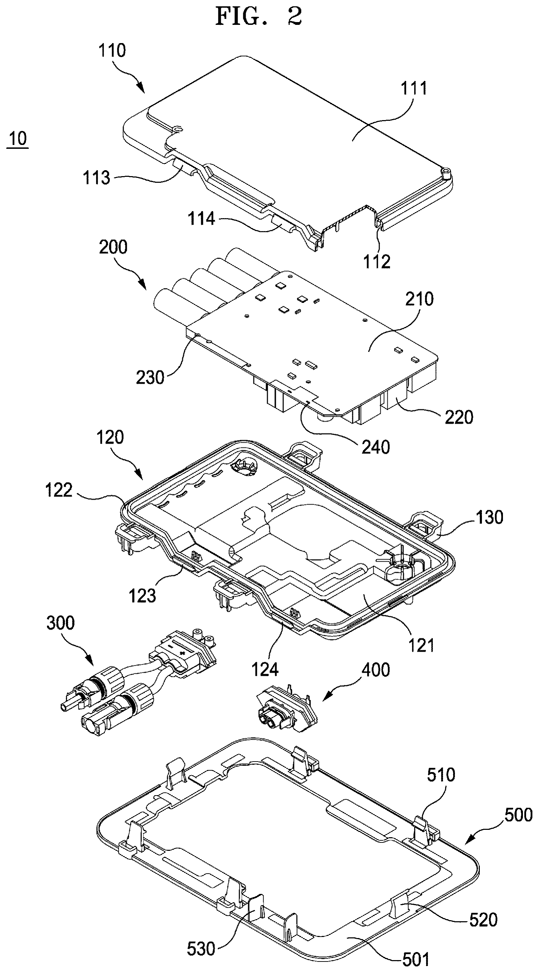

The case 100 may have an internal space. The case 100 may form an exterior of the microinverter 10 and may accommodate a circuit board 200 therein (see FIG. 2). The case 100 may fix a position of the circuit board 200. To this end, an internal shape of the case 100 may correspond to a shape of the circuit board 200.

The case 100 may protect the circuit board 200 disposed therein. For example, in consideration of the stable operation of the microinverter 10 and the influence of the surrounding environment, the case 100 may have functions of heat resistance, moisture resistance, water resistance, electrical insulation, cold resistance, oil resistance, impact resistance, and waterproof.

In an embodiment, the case 100 may include an upper case 110 and a lower case 120. The case 100 may be formed by assembling the upper case 110 and the lower case 120.

The upper case 110 and the lower case 120 may be assembled to form a space therein. The circuit board 200 may be accommodated in an internal space of the upper case 110 and the lower case 120.

The upper case 110 and the lower case 120 may include a connection position for the first connector 300 and the second connector 400. The first connector 300 and the second connector 400 may be interposed between the upper case 110 and the lower case 120. As the upper case 110 and the lower case 120 are assembled, a position at which the first connector 300 is connected and a position at which the second connector 400 is connected may be set.

The support bracket 500 may support a lower surface of the case 100. The support bracket 500 may be connected to the case 100. The support bracket 500 may be installed on a structure in a state of being assembled to the case 100. The microinverter 10 may be installed by being fixed at a desired installation position by the bracket 500.

The case 100 and the support bracket 500 may be assembled by a locking unit. The locking unit may include a first locker and a second locker which are provided to be assembled with each other. When one of the case 100 and the support bracket 500 has the first locker, the other thereof may have the second locker assembled with the first locker.

For convenience of description, hereinafter, descriptions will be provided based on an embodiment in which a first locker 130 is provided on the case 100 and a second locker 510 is provided on the support bracket 500.

According to an embodiment, the first locker 130 may be disposed at on one side of the case 100, and the second locker 510 may be disposed on the support bracket 500 at a position corresponding to the first locker 130. The first locker 130 and the second locker 510 may assembled to fix the case 100 to the support bracket 500. A plurality of first lockers 130 and a plurality of second lockers 510 may be provided.

In an optional embodiment, the support bracket 500 may include a fixing snap 520 and an alignment portion 530.

The fixing snap 520 may be positioned on a different side surface from the locking unit. The fixing snap 520 may be connected to the case 100 to fix the case 100 onto the support bracket 500.

The alignment portion 530 may be positioned adjacent to the second connector 400 connected to the case 100 to align and support a position of a plug connected to the second connector 400.

FIG. 2 is an exploded perspective view of the microinverter 10 of FIG. 1.

Referring to FIG. 2, the microinverter 10 may include the upper case 110, the lower case 120, the circuit board 200, the first connector 300, the second connector 400, and the support bracket 500.

The upper case 110 may include a cover 111, a joint groove 112, a first fitting piece 113, and a second fitting piece 114.

The cover 111 may be provided in a plate shape that covers an upper portion of the circuit board 200. The cover 111 may correspond to a shape of the upper portion of the circuit board 200. A lower surface of the cover 111 may be in contact with the upper portion of the circuit board 200 to fix a position thereof.

The joint groove 112 may be formed in the lower surface of the cover 111. According to an embodiment, the joint groove 112 may be formed along a perimeter of the lower surface of the cover 111. The joint groove 112 may be provided to be connectable to the lower case 120. A portion of the lower case 120 may be fitted into the joint groove 112.

The first fitting piece 113 may be provided at one side of the cover 111 to be in contact with the first connector 300 connected to the case 100. The first fitting piece 113 may be disposed adjacent to a position at which the first connector 300 is connected. For example, the first fitting piece 113 may be provided as a protrusion protruding from one side surface of the upper case 110 toward an upper surface of the first connector 300. The first fitting piece 113 may be fastened to one side of the upper surface of the first connector 300.

The second fitting piece 114 may be provided at the other side of the cover 111 to be in contact with the second connector 400 connected to the case 100. The second fitting piece 114 may be positioned adjacent to a position at which the second connector 400 is connected. For example, the second fitting piece 114 may be provided as a protrusion protruding from the other side surface of the upper case 110 toward an upper surface of the second connector 400. The second fitting piece 114 may be fastened to one side of the upper surface of the second connector 400.

The lower case 120 may include a base 121, a base protrusion 122, a third fitting piece 123, and a fourth fitting piece 124.

The base 121 may support the circuit board 200. The base 121 may be provided in a plate shape that surrounds a lower surface of the circuit board 200. The base 121 may correspond to a shape of the lower surface of the circuit board 200. The circuit board 200 may be seated on an upper surface of the base 121. The upper surface of the base 121 may be in contact with a lower portion of the circuit board 200 to fix a position thereof.

The base protrusion 122 may be formed on the upper surface of the base 121. According to an embodiment, the base protrusion 122 may be formed along a perimeter of the upper surface of the base 121. The base protrusion 122 may be provided to be connectable to the upper case 110. The base protrusion 122 may be inserted into a portion of the upper case 110.

The third fitting piece 123 may be provided at one side of the base 121 to be in contact with the first connector 300 connected to the case 100. The third fitting piece 123 may be disposed adjacent to a position at which the first connector 300 is connected. For example, the third fitting piece 123 may be provided as a protrusion protruding from one side surface of the lower case 120 toward a lower surface of the first connector 300. The third fitting piece 123 may be fastened to one side of the lower surface of the first connector 300.

The fourth fitting piece 124 may be provided at the other side of the base 121 to be in contact with the second connector 400 connected to the case 100. The fourth fitting piece 124 may be positioned adjacent to a position at which the second connector 400 is connected. For example, the fourth fitting piece 124 may be provided as a protrusion protruding from the other side surface of the lower case 120 toward a lower surface of the second connector 400. The fourth fitting piece 124 may be fastened to one side of the lower surface of the second connector 400.

The lower case 120 may include a first locker 130 at one side thereof. The first locker 130 may be disposed at an edge of the lower case 120. The first locker 130 may be provided to be assembled with the second locker 510 of the support bracket.

The circuit board 200 may be disposed between the upper case **110** and the lower case 120. The circuit board 200 may be accommodated in an internal space formed by assembling the upper case **110** and the lower case 120. The circuit board 200 may be supported by the upper case **110** and the lower case 120 so that a position thereof may be fixed.

The circuit board 200 may be formed by arranging preset circuit patterns and circuit components on one surface or opposite surfaces. For example, the circuit board 200 may be provided as a typical printed circuit board assembly (PCBA). Hereinafter, descriptions will be provided based on a case in which the circuit board 200 is used singly, but as needed, the circuit board 200 may be used by integrating a plurality of layers.

The circuit board 200 may be provided to convert DC power into AC power. The first connector 300 may be connected to one side of the circuit board 200, and the second connector 400 may be connected to the other side of the circuit board 200.

According to an embodiment, the circuit board 200 may include a substrate unit 210, a circuit unit 220, a first connection hole 230, and a second connection hole 240.

The substrate unit 210 may have a plate shape and may have a circuit pattern printed on one surface or opposite surfaces or have a surface on which circuit components are disposed. The circuit unit 220 may be disposed on the substrate unit 210.

The circuit unit 220 may include a circuit for converting DC power into AC power. The circuit unit 220 may include components such as a circuit pattern printed with copper, an integrated circuit (IC), a capacitor, and a transformer which are disposed on the substrate unit 210. For example, the circuit unit 220 may include a voltage boosting circuit for boosting an input DC voltage and a conversion circuit for converting DC power into AC power and thus may include respective circuit components.

The first connection hole 230 may be formed in one side of the substrate unit 210, and the second connection hole 240 may be formed in the other side thereof. The first connection hole 230 and the second connection hole 240 may each be formed in a hole shape passing through the substrate unit 210. The first connection hole 230 may define a position at which the first connector 300 is connected to the substrate unit 210, and the second connection hole 240 may define a position at which the second connector 400 is connected to the substrate unit 210.

The first connector 300 and the second connector 400 may be provided to connect the microinverter 10 to the outside. The first connector 300 and the second connector 400 may be connected to an external power source and power system using a cable or other connectors.

According to an embodiment, the first connector 300 may be provided as a DC connector, and the second connector 400 may be provided as an AC connector.

The first connector 300 may be connected directly to the circuit board 200. One side of the first connector 300 may be connected to the circuit board 200 through the first connection hole 230.

A solar cell module (not shown) may be connected to the other side of the first connector 300. The solar cell module is a device that converts light energy into electrical energy through a photovoltaic effect. DC power generated by the solar cell module may be input to the first connector 300. The first connector 300 may transmit the input DC power to the circuit board 200.

The second connector 400 may be connected directly to the circuit board 200. One side of the second connector 400 may be connected to the circuit board 200 through the second connection hole 240.

A power system (not shown) may be connected to the other side of the second connector 400. The second connector 400 may output AC power converted by the circuit board 200. The second connector 400 may transmit the AC power to the power system through an AC output cable.

The support bracket 500 may include the second locker 510, the fixing snap 520, and the alignment portion 530 on a bracket body 501. The bracket body 501 may support a lower surface of the lower case 120 and may have a flat upper surface.

The second locker 510 may be positioned on an upper surface of the bracket body 501 and disposed to correspond to the first locker 130. The second locker 510 may be provided to be assembled to the first locker 130.

The fixing snap 520 may be connected to the case 100 through a typical snap-fit fastening method. A snap-fit fastening method is a method of fitting and fastening a hook into a predetermined groove or one surface and a method of connecting two components without a separate connection member.

According to an embodiment, the fixing snap 520 may have a snap-fit structure that is connected to one side of the upper case 110 or the lower case 120. At least a portion of the fixing snap 520 may have elasticity, and the lower case 120 may be connected to the fixing snap 520 through force fitting.

The alignment portion 530 may be provided as guide walls that protrude from an upper surface of the bracket body 501 and are disposed in parallel to each other at opposite sides of the second connector 400. The alignment portion 530 may align a plug connected to the second connector 400 to allow the plug to be connected at a correct position.

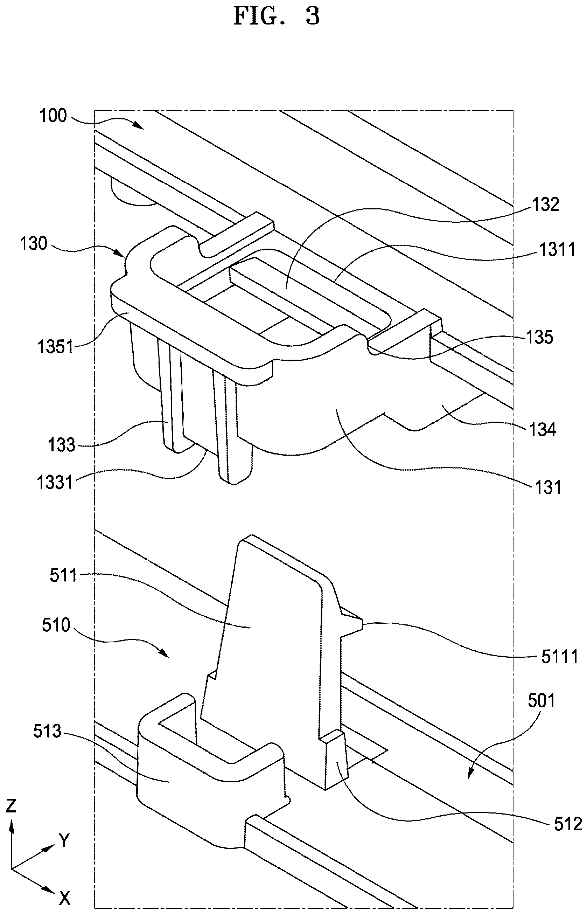

FIG. 3 is an exploded perspective view of the first locker 130 and the second locker 510 of FIG. 1.

Hereinafter, the first locker 130 and the second locker 510 will be described with reference to the drawings. To this end, with respect to the microinverter 10 shown in the drawing, a lateral direction is referred to as an X-axis direction, an anteroposterior direction is referred to as a Y-axis direction, and a vertical direction is referred to as a Z-axis direction.

Referring to FIG. 3, the first locker 130 may be disposed on the case 100, and the second locker 510 may be disposed on the bracket body 501.

The first locker 130 may include a buckle 131, a support bar 132, a mount protrusion 133, a supporter 134, and a protective wall 135.

The buckle 131 may be formed to extend from an edge of the case 100. The buckle 131 may have a polygonal or oval ring shape that is in contact with an edge surface of the case 100. The buckle 131 may have an insertion opening 1311 perforated in the Z-axis direction.

The support bar 132 may be positioned across the insertion opening 1311. The support bar 132 may be formed in a bar shape extending in the X-axis direction. At least a portion of the support bar 132 may have elasticity. Accordingly, the support bar 132 may be restored after being partially bent by an external force.

The mount protrusion 133 may be formed to extend downward from the buckle 131. The mount protrusion 133 may be provided as a protrusion that is positioned on an outermost surface of the buckle 131 and protrudes downward along a Z-axis. The mount protrusion 133 may be positioned to face a mount groove 513 of the second locker 510.

According to an embodiment, a pair of mount protrusions 133 may be provided. A joint piece 1331 may be disposed between the pair of mount protrusions 133. The joint piece 1331 may be formed as a wall portion connecting the pair of mount protrusions 133. The joint piece 1331 may be formed to have a thickness that is less than or equal to a thickness of the mount protrusion 133.

The supporter 134 may be disposed below the buckle 131 to support a lower surface of the buckle 131. The buckle 131 may be connected to one side of the case 100 by the supporter 134. For example, the supporter 134 may be formed in a wall shape extending from the buckle 131 and installed at the edge of the case 100. As another example, the supporter 134 may be formed in a plate shape integrated with the buckle 131 and the case 100.

The protective wall 135 may be positioned on the buckle 131 and formed to extend upward from the buckle 131. The protective wall 135 may be provided as a wall that is disposed on an outermost surface of the buckle 131 and forms a height in an upward direction along the Z axis. The protective wall 135 may be formed in a shape that surrounds the front of the insertion opening 1311.

A handle 1351 may be formed at an upper end portion of the protective wall 135. The handle 1351 may provide a hand-held portion when the first locker 130 and the second locker 510 are assembled or separated.

The second locker 510 may include a hook 511, a reinforcement piece 512, and the mount groove 513.

The hook 511 may be formed to extend upward from the bracket body 501. At least a portion of the hook 511 may have elasticity, and the hook 511 may be restored after being partially bent by an external force.

A width of the hook 511 may be decreased in an extending direction, and thus a cross-sectional area thereof may be decreased. Accordingly, when an external force is applied to the hook 511, an upper end portion of the hook 511 may be easily bend, but a lower portion thereof may have rigidity.

A locking protrusion 5111 may be provided at the upper end portion of the hook 511. The locking protrusion 5111 may be formed to protrude from a surface of the hook 511 facing the case 100.

The reinforcement piece 512 may be disposed on each of opposite side surfaces of a lower portion of the hook 511. The reinforcement piece 512 may be positioned at a connection portion between the hook 511 and the bracket body 501. The reinforcement piece 512 may be formed in a plate shape protruding from the side surface of the hook 511. The reinforcement piece 512 may reinforce the rigidity of the lower portion of the hook 511 to prevent damage to the hook 511.

The mount groove 513 may be formed in the upper surface of the bracket body 501. The mount groove 513 may be positioned adjacent to the hook 511 and spaced apart from the hook 511 in the Y-axis direction. The mount groove 513 may be positioned to vertically face the mount protrusion 133 of the first locker 130. The mount groove 513 may be provided such that the mount protrusion 133 may be inserted therein.

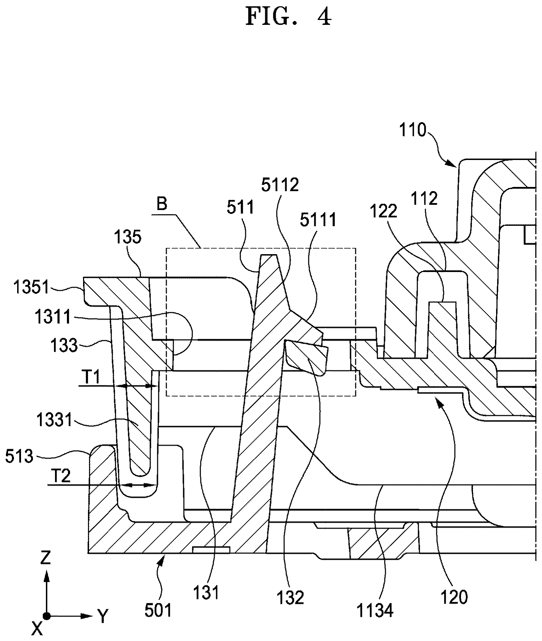

FIG. 4 is a partial cross-sectional view taken along line IV-IV' of FIG. 1.

Referring to FIGS. 1 to 4, the case 100 formed by assembling the upper case 110 and the lower case 120 may be assembled to the support bracket 500 to form an exterior of the microinverter 10.

The joint groove 112 and the base protrusion 122 may be formed in shapes corresponding to each other. The base protrusion 122 may be inserted into the joint groove 112 so that the upper case 110 and the lower case 120 may be assembled. The assembled case 100 may be disposed on the bracket body 501.

Referring to FIG. 4, the first locker 130 and the second locker 510 may be provided to be assembled with each other, thereby connecting the lower case 120 and the support bracket 500.

Specifically, while the hook 511 is assembled to the buckle 131 from bottom to top, and simultaneously the mount protrusion 133 is assembled from top to bottom, a coupling force between the first locker 130 and the second locker 510 may be generated doubly in the Z-axis direction.

The buckle 131 may be formed at the edge of the lower case 120 and may have the insertion opening 1311. The supporter 134 extending from the lower case 120 may support the lower surface of the buckle 131.

The supporter 134 may be provided as a wall portion extending between the buckle 131 and the lower case 120. Since the supporter 134 is formed as a shape integrated with the buckle 131 and the lower case 120, the structural stability of the buckle 131 may be improved.

The hook 511 may be inserted into the insertion opening 1311 of the buckle 131. The locking protrusion 5111 positioned at the upper end portion of the hook 511 may be fastened to be caught by the support bar 132. The hook 511 and the support bar 132 may have a predetermined elastic force and thus may be partially bent to be easily fastened to each other. Accordingly, a coupling force in the Z-axis direction may be formed between the hook 511 and the support bar 132.

The mount protrusion 133 may be provided as a protrusion extending downward from the buckle 131. The mount protrusion 133 may have a thickness that is gradually decreased downward along the Z-axis. An upper portion of the mount protrusion 133 may have a first thickness T1, and a lower portion thereof may have a second thickness T2. The first thickness T1 may be provided to be greater than the second thickness T2.

In this case, the pair of mount protrusions 133 may be provided, and a space between two mount protrusions 133 may be connected by the joint piece 1331. Since the joint piece 1331 is provided to be thinner than the mount protrusion 133, when an external force is applied to the mount protrusions 133 at opposite sides, an elastic force and a buffering force may be generated in the joint piece 1331.

When the mount protrusion 133 is inserted into the mount groove 513, since the pair of mount protrusions 133 are supported on sidewalls of the mount groove 513 which are opposite to each other in the X-axis direction, a coupling force in the X-axis direction may be generated between the first locker 130 and the second locker 510.

Since a thickness and cross-sectional area of the mount protrusion 133 decrease in an extending direction, the mount protrusion 133 may be easily inserted when first inserted into the mount groove 513. Afterwards, since the inserted mount protrusion 133 has a section of which a thickness is equal to an inner width of the mount groove 513, frictional resistance is generated on a contact surface between the mount protrusion 133 and the mount groove 513 so that the mount protrusion 133 and the mount groove 513 may be fastened to each other. Accordingly, when the mount protrusion 133 is assembled to the mount groove 513 and the locking protrusion 5111 of the hook 511 is supported by the support bar 132, a coupling force in the Z-axis direction may be generated between the first locker 130 and the second locker 510.

According to an embodiment, a coupling force in the Y-axis direction may be generated doubly between the first locker 130 and the second locker 510.

The hook 511 may protrude upward and may be formed to be inclined in one direction without being perpendicular to the bracket body 501. The hook 511 may be provided to be inclined toward the case 100. A repulsive force may be formed on a contact surface between the hook 511 and the support bar 132. A force in a -Y direction may act on the hook 511, and a force in a +Y direction may act on the support bar 132. Accordingly, a coupling force in the Y-axis direction may be generated between the hook 511 and the support bar 132.

The mount protrusion 133 may protrude in a thickness direction of the buckle 131 and may protrude further outward from the buckle 131 than toward the insertion opening 1311. That is, the mount protrusion 133 may be formed to be biased further to an outer surface of the buckle 131 than an inner surface of the buckle 131. Therefore, as shown in FIG. 4, the mount protrusion 133 may be in close contact with an inner surface of the mount groove 513. A repulsive force may be generated on the contact surface between the mount protrusion 133 and the mount groove 513. A force in the +Y direction may act on the mount protrusion 133, and a force in the -Y direction may act on the mount groove 513. Accordingly, a coupling force in the Y-axis direction may be generated between the mount protrusion 133 and the mount groove 513.

In an optional embodiment, the hook 511 may further include a push piece 5112 at the upper end portion thereof. The push piece 5112 may be provided as an inclined surface between the upper end portion of the hook 511 and the locking protrusion 5111. By pressing the push piece 5112, the hook 511 may be bent in a direction away from the case 100, and the hook 511 and the support bar 132 may be disconnected from each other.

The protective wall 135 may be positioned on the buckle 131 and formed to surround at least a portion of the insertion opening 1311. In an embodiment, the protective wall 135 may be provided as a wall extending from the buckle 131 in a height direction. Since the protective wall 135 is formed to surround at least a front side surface of the insertion opening 1311, a fastening area between the hook 511 and the support bar 132 may be protected.

The handle 1351 may be disposed at an upper side of the protective wall 135. The handle 1351 may be formed by a portion extending from an outer surface of the protective wall 135 in a thickness direction.

A user may easily assemble the first locker 130 and the second locker 510 by grabbing the handle 1351 and handling the case 100. In addition, the user may easily separate the first locker 130 and the second locker 510 by grabbing the handle 1351 and pushing the push piece 5112 of the buckle.

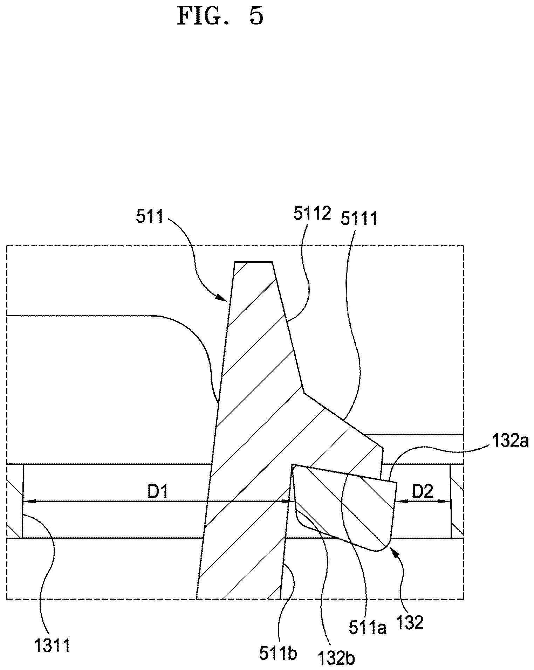

FIG. 5 is an enlarged view of part B of FIG. 4.

Referring to FIG. 5, the support bar 132 may be spaced apart from one side of the insertion opening 1311 by a first interval D1 and may be spaced apart from the other side of the insertion opening 1311 by a second interval D2 different from the first interval D1.

The hook 511 may be inserted into a portion of the insertion opening 1311 having the first interval D1. When a force is applied to the push piece 5112 to rotate the hook 511, the hook 511 may rotate within the first interval D1.

The support bar 132 is provided to have a predetermined elastic force and has a free space as much as the second interval D2 in the insertion opening 1311, the support bar 132 may be bent and restored.

The support bar 132 may have a first bar inclined surface 132a on an upper surface in contact with the locking protrusion 5111 of the hook and a second bar inclined surface 132b on a side surface facing the inside of the hook. In this case, a corner formed between the first bar inclined surface 132a and the second bar inclined surface 132b may be formed as a curved surface.

The hook 511 may have a first hook inclined surface 511a on a lower surface of the locking protrusion 1511 and a second hook inclined surface 511b on a side surface facing the support bar 132.

The first bar inclined surface 132a and the first hook inclined surface 511a may have the same inclination angle to have a first inclination. The first hook inclined surface 511a may be in full contact with the first bar inclined surface 132a.

The second bar inclined surface 132b and the second hook inclined surface 511b may have different inclination angles. The second bar inclined surface 132b may have a second inclination, and the second hook inclined surface 511b may have a third inclination different from the second inclination. The second bar inclined surface 132b and the second hook inclined surface 511b may not be in contact with each other.

When a force is applied to the push piece 5112 to outwardly rotate the hook 511 so as to separate the hook 511 and the support bar 132, since the corner between the first bar inclined surface 132a and the second bar inclined surface 132b has the curved surface, the first hook inclined surface 511a may easily slide relative to the first bar inclined surface 132a.

In addition, since the second hook inclined surface 511b is not in contact with the second bar inclined surface 132b, frictional resistance may not be generated therebetween, and thus the rotation of the hook 511 may not be impeded.

According to an embodiment, the hook 511 and the support bar 132 may remain assembled when a force is not applied to the push piece 5112 and may be provided to be separated from each other only when necessary. To this end, the first inclination may be designed to have an inclination angle that allows the hook 511 to be rotated only when a force is applied to the push piece 5112. The second inclination may be provided to be different from the first inclination and may be designed to have an appropriate inclination angle in consideration of a curvature of the corner between the first bar inclined surface 132a and the second bar inclined surface 132b. The third inclination may be designed to have an inclination angle such that the second bar inclined surface 132b is not in contact with the second hook inclined surface 511b.

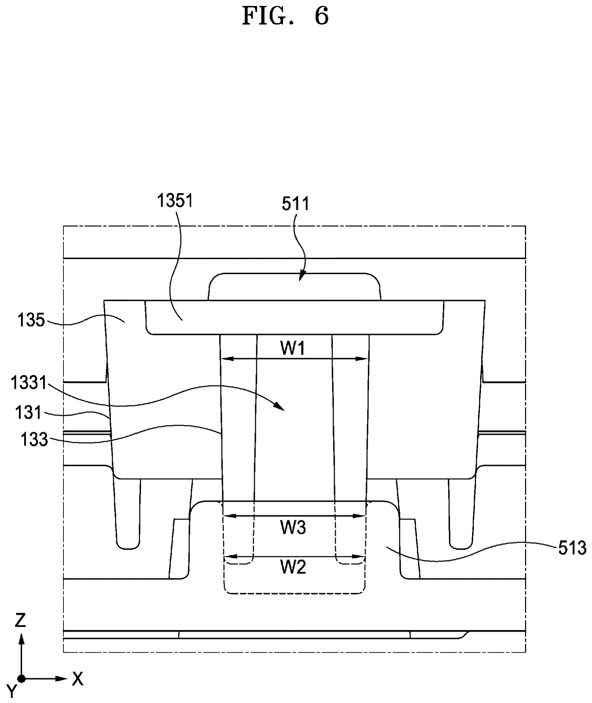

FIG. 6 is a front view of part A of FIG. 1.

Referring to FIGS. 1 and 6, the mount protrusion 133 may be formed as a pair of protrusions which extend downward from the buckle 131 and are spaced apart from each other by a predetermined width. The pair of mount protrusions 133 may be connected by the joint piece 1331. As described above, the joint piece 1331 may generate an elastic force and a buffering force between the pair of mount protrusions 133.

According to an embodiment, the mount protrusion 133 may have a width that is gradually decreased downward along the Z-axis. An upper portion of each of the pair of mount protrusions 133 may have a first width W1, and a lower portion thereof may have a second width W2.

An inner width of the mount groove 513 may be a third width W3. The third width W3 may be less than the first width W1 and may be greater than the second width W2.

Since the thickness and cross-sectional area of the mount protrusion 133 decreases in the extending direction, the mount protrusion 133 may be easily inserted when first inserted into the mount groove 513. The mount protrusion 133 may have a section in which a width of an inserted portion thereof is equal to the third width W3, and the pair of mount protrusions 133 may be fitted into and coupled to the inside of the mount groove 513.

When the pair of mount protrusions 133 are fitted into the mount groove 513, pressure may be applied to the mount protrusions 133 at opposite sides. Since the joint piece 1331 generates a predetermined elastic force and a predetermined buffering force against pressure applied in both directions, the mount protrusion 133 and the mount groove 513 may be in more close contact with each other. Accordingly, a coupling force in the X-axis direction may be generated between the mount protrusion 133 and the mount groove 513. Even when a twisting force is laterally applied to an assembly portion between the mount protrusion 133 and the mount groove 513, resistance to the twisting force may be generated.

In the microinverter 10 according to an embodiment of the present disclosure, the first locker 130 and the second locker 510 connecting the case 100 and the support bracket 500 may form a firm assembly structure. Thus, the microinverter 10 may have improved resistance to external impact, and an assembled portion may be prevented from being detached or damaged during transportation.

In the microinverter 10 according to an embodiment of the present disclosure, the first locker 130 and the second locker 510 may generate a strong assembly force and a strong coupling force in a three-axis direction so that a stable assembly state may be maintained. The mount protrusion 133 of the first locker 130 is inserted into the mount groove 513 of the second locker 510, and the hook 511 of the second locker 510 is inserted into the buckle 131 and supported by the support bar 132.

In this case, the pair of mount protrusions 133 are supported on opposite sidewalls of the mount groove 513 which opposite to each other in the X-axis direction so that the first locker 130 and the second locker 510 are firmly coupled in the X-axis direction.

In addition, since the hook 511 and the mount groove 513 are spaced apart from each other in the Y-axis direction, the mount protrusion 133 is supported on a wall of the mount groove 513 extending in the X-axis direction, and the hook 511 having elasticity is supported by the support bar 132, the first locker 130 and the second locker 510 are firmly coupled in the Y-axis direction.

In addition, since the locking protrusion 5111 of the hook 511 is supported by the support bar 132 and the pair of mount protrusions 133 are inserted into the mount groove 513, the first locker 130 and the second locker 510 are firmly coupled in the Z-axis direction.

In the microinverter 10 according to an embodiment of the present disclosure, a coupling between the case 100 and the support bracket 500 may be reinforced, thereby protecting the circuit board 200 and other components embedded in the case 100 and stably operating conversion performance.

The present disclosure has been described with reference to embodiments shown in the accompanying drawings, but this is merely illustrative, and those skilled in the art will understand that various modifications and other equivalent embodiments are possible therefrom. Therefore, the true scope of the present disclosure should be determined only by the appended claims.

## Claims

1. A microinverter comprising:
a case in which a circuit board is disposed therein;
a first connector disposed at one side of the case and connected to the circuit board;
a second connector disposed at another side of the case and
connected to the circuit board; and
a support bracket configured to support the case,
wherein one of the case and the support bracket comprises a first locker disposed at an edge thereof, and
the other one of the case and the support bracket comprises a second locker assembled with the first locker.

2. The microinverter of claim 1, wherein the first locker comprises:
a buckle extending from the edge and having an insertion opening;
a support bar extending across the insertion opening; and
a mount protrusion extending downward from the buckle.

3. The microinverter of claim 2, wherein the mount protrusion protrudes in a thickness direction of the buckle and protrudes further outward of the buckle than toward the insertion opening.

4. The microinverter of claim 2, wherein a cross-sectional area of the mount protrusion decreases in a direction in which the mount protrusion extends from the buckle.

5. The microinverter of claim 2, wherein the support bar is spaced apart from one side of the insertion opening by a first interval and is spaced apart from another side of the insertion opening by a second interval different from the first interval.

6. The microinverter of claim 2, wherein an upper surface of the
support bare in contact with the second locker has a first inclination, and
a side surface of the support bar facing the second locker has a second inclination.

7. The microinverter of claim 1, wherein the second locker comprises:
a hook supported by the buckle of the first locker; and
a mount groove into which mount protrusions of the first locker are inserted.

8. The microinverter of claim 7, wherein the hook has an inclination in a height direction.

9. The microinverter of claim 7, wherein the pair of mount protrusions support an inner surface of the mount groove.

10. The microinverter of claim 7, wherein the hook comprises a locking protrusion supported by a support bar of the first locker.
